(19) Europäisches Patentamt

European Patent Office

Office européen des brevets

(11) EP 0 708 847 B1

(12) FASCICULE DE BREVET EUROPEEN

(45) Date de publication et mention
de la délivrance du brevet:
**26.03.1997 Bulletin 1997/13**

(21) Numéro de dépôt: **94922898.5**

(22) Date de dépôt: **11.07.1994**

(51) Int Cl.⁶: **C25D 5/56**, C23C 18/28

(86) Numéro de dépôt international:
**PCT/FR94/00860**

**WO 95/02715 (26.01.1995 Gazette 1995/05)**

(54) **PROCEDE DE METALISATION DE SUBSTRATS NON-CONDUCTEURS**

VERFAHREN ZUR METALLISIERUNG VON NICHTLEITENDEN SUBSTRATEN

METHOD FOR METALLISING NON-CONDUCTIVE SUBSTRATES

(84) Etats contractants désignés:
**AT BE CH DE ES FR GB GR IE IT LI LU NL PT SE**

(30) Priorité: **16.07.1993 FR 9308986**

(43) Date de publication de la demande:
**01.05.1996 Bulletin 1996/18**

(73) Titulaire: **TREFIMETAUX**
**92400 Courbevoie (FR)**

(72) Inventeurs:
• **NEGRERIE, Marcel**
**F-95240 Cormeilles-en-Parisis (FR)**

• **DE HOLLAIN, Guy, Domaine de Marsinval**
**F-78540 Vernouillet (FR)**
• **N'GUYEN, Van Huu**
**F-95800 Cergy-St-Christophe (FR)**
• **INSENGA, Serge**
**F-95540 Mery-sur-Oise (FR)**

(74) Mandataire: **Mougeot, Jean-Claude et al**
**PECHINEY**
**28, rue de Bonnel**
**69433 Lyon Cedex 03 (FR)**

(56) Documents cités:
FR-A- 2 518 126          US-A- 3 146 125
US-A- 3 226 256

**Description**

DOMAINE DE L'INVENTION

L'invention concerne un procédé de métallisation de substrats non-conducteurs.

ART ANTERIEUR

On connaît déjà de nombreux procédés pour former une couche métallique sur un substrat ou support non-conducteur, qu'il s'agisse de verre, de matériaux plastiques, de matériaux composites à matrice non-conductrice, de papier, de matériaux céramiques, etc....

Une première famille de procédés fait appel au dépôt par évaporation sous vide de métal liquide grâce à divers moyens de chauffage (effet Joule, bombardement électronique, pulvérisation cathodique, etc...). Ainsi, peut-on déposer une couche d'aluminium sur des films typiquement en matière plastique (PET par exemple).

Comme variantes de ces procédés, on trouve les procédés de dépôts par voie chimique connus sous l'appellation "CVD" (chemical vapour deposition), éventuellement à l'aide d'un plasma (procédés PEVD = Plasma Enhanced Vapour Deposition).

On connaît aussi les procédés de dépôts chimiques et électrochimiques de métaux.

Ces procédés sont considérés comme classiques dans le cas de supports conducteurs.

Dans le cas de supports non-conducteurs, un traitement préalable est nécessaire avant de procéder au dépôt chimique ou électrochimique proprement dit.

Ce traitement peut être une métallisation sous vide, comme décrit dans la demande de brevet FR-A1-2 558 485 relative à la fabrication d'une structure métallique poreuse.

Ce traitement peut être aussi un traitement d'activation à base de métaux nobles (argent, palladium, or), comme décrit dans l'ouvrage "Electroplating of Plastics - J. Christof et al. - Finishing Publications Ltd 1977 - UK", ou encore dans l'ouvrage "Surface Finishing Systems : Metal and Non-Metal Finishing Handbook-Guide - by George J. Rudzki - Finishing Publications Ltd 1983 - England".

Le procédé typique comprend la succession d'étapes suivantes :

*   attaque du substrat à l'acide chromique,
*   traitement par une solution de chlorure stanneux,
*   traitement par une solution contenant un métal noble tel que Ag, Pd, Au,
*   immersion dans un bain dit "electroless" (dépôt chimique, ou autocatalytique) permettant de déposer des métaux tels que l'argent, le cuivre, le nickel ou l'étain (dépôt relativement lent),
*   enfin, revêtement électrolytique du métal à déposer (dépôt beaucoup plus rapide que le dépôt chimique - étape obligée pour obtenir une surface conductrice).

Il existe enfin des procédés dans lesquels le traitement préalable, nécessaire à la mise en oeuvre de dépôts chimiques ou électrochimiques classiques (respectivement, réduction d'un sel métallique par voie chimique - à l'aide d'un réducteur - ou par voie électrochimique), a consisté à incorporer au substrat des charges conductrices telles que des paillettes ou des poudres conductrices (poudres métalliques, fibres de carbone, graphite, etc...), ou de charges rendues conductrices par réduction.

Ainsi, la demande française FR-A-2 544 340 décrit un procédé de fabrication d'un film conducteur comprenant les étapes suivantes :

*   on forme un collodion d'une résine thermodurcissable contenant 20 à 60 % en poids de Cu2O en poudre,
*   on forme un film à partir de ce collodion,
*   on étire le film ou on le décape mécaniquement pour révéler en surface (mettre au jour) des grains de Cu2O,
*   on réduit les grains de Cu2O de surface par un borohydrure,
*   puis on effectue un dépôt électrolytique.

De même, dans la demande française FR-A-2 518 126, on décrit un procédé pour métalliser un objet de forme par dépôt électrolytique comprenant les étapes suivantes (exemple 1) :

-   formation d'un mélange de matière prépolymérique et de poudre de Cu2O,
-   mise en forme du mélange pour obtenir ledit objet et réticulation de la matière prépolymérique,
-   traitement des faces dudit objet avec un abrasif doux, dépoussiérage et traitement dans la cuve à ultrasons, pour révéler les grains de Cu2O,

- formation de cuivre par réduction de Cu2O au borohydrure,
- puis dépôt électrolytique de cuivre.

On connaît aussi des procédés qui permettent d'effectuer un dépôt métallique electroless sans avoir à faire appel à une traitement d'activation par un métal noble.
Ainsi, les brevets US 3146125 et US 3226256 divulgent des procédé qui comprennent typiquement les étapes suivantes :

- préparation d'un mélange de prépolymère et de poudre de Cu2O,
- mise en forme de ce mélange, ou application de ce mélange comme une encre sur un support isolant,
- réticulation de ce mélange,
- abrasion éventuelle de la surface, pour révéler les grains de Cu2O,
- dismutation de Cu2O par l'acide sulfurique,
- puis dépôt métallique electroless.

On connaît enfin des procédés, comme décrit dans le brevet US 4,327,125, dans lesquels on dépose sur la surface non-conductrice à cuivrer un colloïde de particules de Cu, formé à partir d'un sel de cuivre et d'un réducteur, puis on réalise un dépôt chimique de cuivre dans un bain electroless.

OBJETS DE L'INVENTION

L'objet de l'invention est un traitement d'une surface non conductrice quelconque, et de forme quelconque, permettant d'effectuer ensuite une métallisation, non seulement par dépôt electroless, mais surtout par dépôt électrolytique, ce qui est avantageux sur le plan économique compte tenu de la grande vitesse de dépôt de la voie électrolytique.

DESCRIPTION DE L'INVENTION

L'invention peut être mise en oeuvre selon deux modalités pratiques.
Selon une première modalité de l'invention, le procédé de fabrication d'un dépôt métallique continu sur un substrat non-conducteur comprend les étapes suivantes :

a) on prépare une dispersion d'un oxyde de cuivre à l'état divisé, apte à être transformé, au moins en partie, à l'état de cuivre métallique par l'action d'un réactif, comprenant un solvant et un liant sélectionné pour former, après élimination du solvant, un film perméable audit réactif,
b) on applique ladite dispersion sur ledit substrat non-conducteur, et on forme une couche mince sur ledit substrat non-conducteur comprenant ledit oxyde de cuivre à l'état divisé, d'épaisseur inférieure à 30 $\mu$m,
c) on forme du Cu à partir dudit oxyde de cuivre par action dudit réactif, de manière à obtenir à la surface du substrat non-conducteur une couche mince comprenant du Cu,
d) on dépose sur ladite couche comprenant du Cu au moins une couche métallique par dépôt électrolytique d'au moins une espèce métallique ionique en solution.

Ainsi, comparativement à l'art antérieur, l'invention constitue un procédé plus simple et plus économique : il suffit d'une part de réaliser une dispersion d'oxyde de cuivre, ce qui est obtenu à partir de produits du commerce et de l'appliquer, sans moyens particuliers, à la manière d'une peinture, d'une encre ou d'un vernis, sur n'importe quel substrat non-conducteur ayant le plus souvent - mais pas nécessairement - sa forme définitive, et d'autre part de transformer tout ou partie de cet oxyde en Cu, de manière connue en elle-même, avant de réaliser un dépôt métallique par dépôt électrolytique.
Certes, on connaissait déjà l'utilisation de Cu2O dans des traitements de métallisation de l'art antérieur en vue de permettre un dépôt électrolytique subséquent, mais dans des conditions totalement différentes, puisque, dans la demande FR-A-2 518 126, le Cu2O est, non pas déposé en surface, mais intimement lié au substrat non-conducteur lui-même, ce dernier étant mis en forme en présence de Cu2O. La surface de l'objet de forme obtenu est ensuite abrasée pour permettre l'action d'un borohydrure comme agent réducteur de Cu2O, de manière à obtenir une grande conductivité électrique.
Un tel procédé ne serait donc pas applicable, comme selon l'invention, à un substrat quelconque tel qu'une mousse poreuse, avec une surface intérieure de pores inaccessible à une action d'abrasion.
La présente invention présente un caractère particulièrement surprenant dans la mesure où, en dépit du fait que, par les étapes a) à c), on forme une couche mince contenant peu de cuivre et donc relativement peu conductrice, il est possible selon l'invention de former ensuite une couche métallique par dépôt électrolytique.

Alors que la résistivité superficielle obtenue après le traitement décrit dans la demande française FR 2 518 126 est comprise entre 0,01 et 1000 ohm/□, celle obtenue après les étapes a) à c) selon l'invention, se situe à un niveau beaucoup plus élevé, pouvant atteindre $20.10^6$ ohm/□, soit une résitivité 20 000 fois plus élevée que celle indiquée dans la demande FR 2 518 126.

Par ailleurs, les études entreprises par la demanderesse ont montré que les possibilités d'effectuer un dépôt métallique par voie électrolytique n'étaient pas corrélées à ce critère de résitivité, contrairement à ce que pouvait laisser supposer l'étude de l'état de la technique. Voir exemple 3. Par contre, ces études ont montré que la nature et l'état du liant (réticulé ou non) jouaient un rôle décisif, comme illustré dans les exemples 5 et 6.

## DESCRIPTION DES FIGURES

Toutes les figures sont relatives à l'invention.

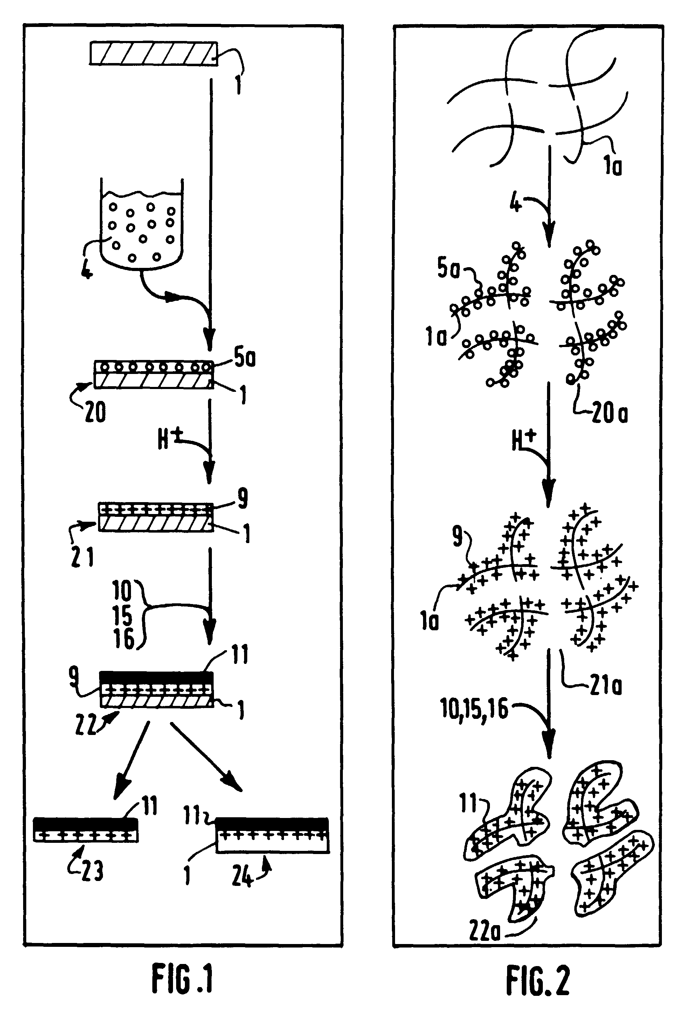

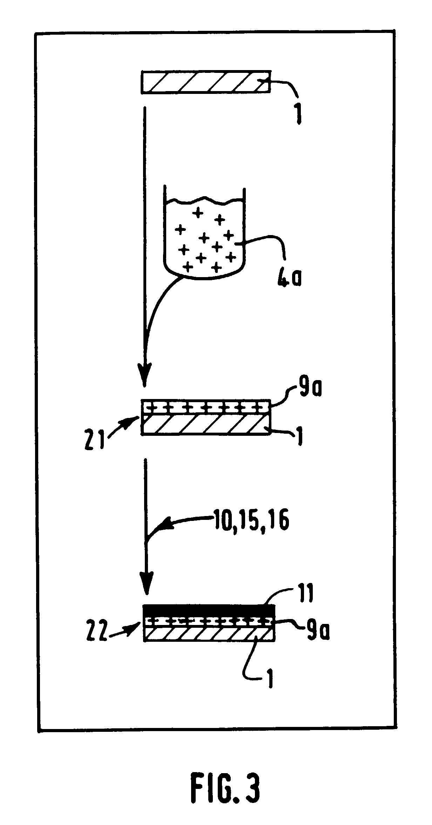

Les figures 1 à 3 illustrent les différentes étapes du procédé selon différentes variantes relatives soit à la nature du substrat non-conducteur (1) (matériau sans porosité ouverte à la figure 1 - matériau cellulaire à porosité ouverte à la figure 2), soit à la nature de la dispersion appliquée sur ce substrat (1) (dispersion (4) contenant de la poudre de Cu2O aux figures 1 et 2 - dispersion (4a) contenant une poudre conductrice à la figure 3).

Dans le procédé représenté à la figure 1, le substrat (1) est enduit sur une face d'une dispersion (4), en milieu solvant, de poudre de Cu2O (représenté par de petits cercles) et de liant selon l'invention, de manière à obtenir, après élimination dudit solvant par séchage, le matériau multicouches (20) formé par le support (1) revêtu d'un couche mince (5a) contenant Cu2O et le liant selon l'invention. Après immersion dans une solution acide, on obtient le matériau multicouches (21) formé par le support (1) revêtu d'une couche mince (9) contenant des particules conductrices (Cu) (représenté par des croix). Après dépôt électrolytique de métal dans un bain d'électrolyse (10), muni d'une cathode (15) et d'une anode (16), on obtient le matériau multicouches (22) comprenant la couche métallique (11) d'épaisseur souhaitée. Ce matériau multicouches peut aussi ensuite être transformé, soit en séparant le substrat de manière à obtenir un matériau (23) essentiellement métallique, soit en traitant thermiquement le matériau (22) de manière à obtenir un matériau (24) en réticulant ledit liant et en solidarisant ainsi ledit substrat (1) et ladite couche métallique (11).

A la figure 2, qui diffère de la figure 1 par la nature du substrat, on a appliqué le procédé de l'invention à une mousse (la) à porosité ouverte (schématisée par la représentation d'un pore en coupe). Par immersion de la mousse dans la dispersion (4) puis retrait et séchage, on obtient le matériau (20a) dans lequel toute la surface des pores est recouverte d'une couche (5a) comprenant Cu2O et le liant selon l'invention.

Par traitement acide, on forme le matériau (21a) dans lequel la surface des pores est recouverte d'une couche (9) comprenant des particules conductrices (Cu) et ledit liant. Puis, par dépôt électrolytique, on obtient un matériau (22a) dont toute la surface des pores est recouverte d'une couche métallique (11).

Dans la figure 3, analogue à la figure 1, la dispersion (4a) contient des particules conductrices, au lieu de contenir du Cu2O comme dans la dispersion (4) de la figure 1. Après application d'un film mince de cette dispersion et séchage, on obtient le matériau (21) comprenant une couche (9a) de particules conductrices dans ledit liant.

La figure 4 représente le montage électrique permettant de déterminer la résistivité de surface du matériau (9,9a). Cette résistivité (ohm/□) est donnée par la formule : $3,14. \Delta V / (l.\ln 2)$, les électrodes de mesure étant distantes de 25 mm les unes des autres.

Les figures 5, 5a et 6 illustrent, en coupe, une manière préférée de former par électrolyse la couche métallique (11), dans un bain (10), le transport du courant étant assuré par la cathode (15) et l'anode (16):

- On forme d'abord un film métallique "primaire" (14) par croissance du film métallique depuis le point de contact électrique avec la couche (9), de manière à recouvrir progressivement toute la surface de la couche (9).

La figure 5a représente une vue de face où le film métallique (14) recouvre environ la moitié de la surface de la couche (9) et progresse vers le bas dans le sens de la flèche, le point de contact électrique avec la couche (9) ayant été placée à l'extrémité supérieure de la couche (9).

- Puis, une fois formé le film métallique sur toute la surface S de la couche (9), on poursuit l'électrolyse pour augmenter l'épaisseur du film métallique (14) et obtenir la couche métallique (11).

La figure 6 schématise, sur un diagramme $J = f(t)$ où J, en ordonnée, représente l'intensité du courant en A, la surface S étant dans ce cas de 1 $dm^2$, et où t représente, en abscisse, le temps en minutes des deux étapes de l'électrolyse :

La première étape, de durée notée $\Delta t_s$, vise le recouvrement progressif de la toute la surface S de la couche (9) par le film métallique (14) d'épaisseur $E_i$, ce qui a lieu avec une augmentation progressive de la densité de courant.

La seconde étape, de durée notée $\Delta t_E$, vise à augmenter l'épaisseur de la couche métallique, qui passe de l'épaisseur $E_i$ initiale à l'épaisseur $E_f$ dans la couche métallique finale (11).

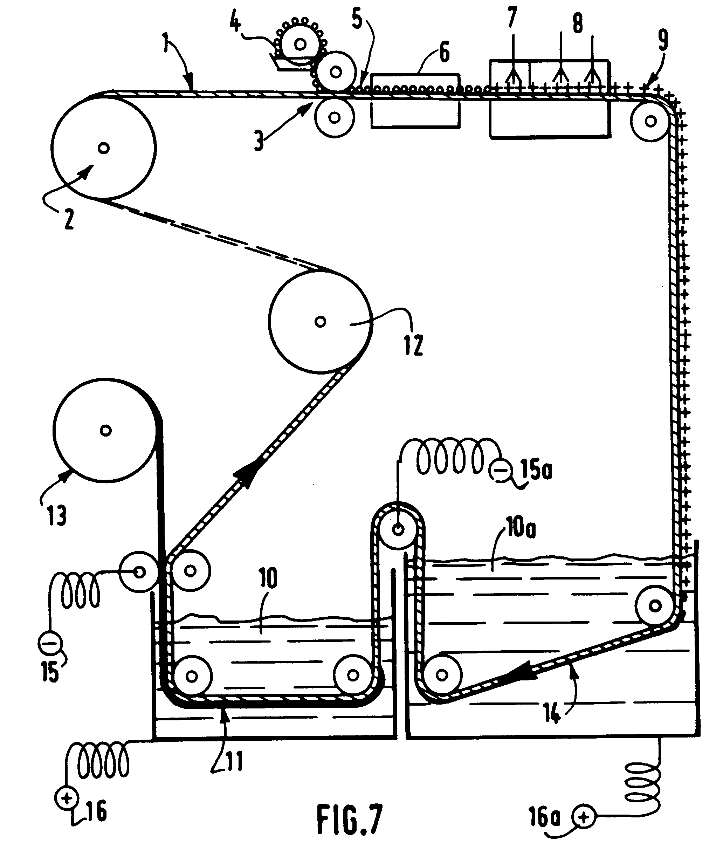

La figure 7 représente, en coupe transversale, le schéma d'une installation de dépôt électrolytique pour mettre en oeuvre une modalité de l'invention visant à produire en continu une bande métallique (13). Ce schéma permet d'illustrer le procédé selon une modalité de l'invention.

Le substrat (1) est un film plastique en bobine (représenté par une bande hachurée latéralement).

L'installation comprend successivement :

- des moyens (2) d'alimentation en substrat (1),
- des moyens (3) pour appliquer sur le substrat (1), une couche mince (5) (représentée par des ronds) d'une dispersion (4) de Cu2O dans un solvant,
- des moyens (6) de séchage de ladite couche mince (5),
- des moyens (7) de lavage acide de ladite couche mince (5) et des moyens de rinçage (8) à l'eau, conduisant à la formation de ladite couche mince (9) comprenant du Cu (représentée par des croix),
- des moyens assurant le dépôt électrolytique d'une couche métallique (11) dans deux bains successifs :

Dans le premier (10a), la concentration en sel métallique et les paramètres électriques, tension de courant entre la cathode (15) et l'anode (16a) et intensité, sont choisis de manière à obtenir en sortie de bain un film métallique de quelques µm d'épaisseur $E_i$.

Dans le second bain (10), l'intensité du courant passant par la cathode (15) et l'anode (16) est supérieure à celle dans le premier bain, et adaptée à la formation rapide d'une couche métallique (11) d'épaisseur $E_f$ souhaitée.

En sortie de bain d'électrolyse, la bande plastique servant de support (1) est séparée de la bande métallique (13). Eventuellement, la bande plastique est réintroduite en tête de dispositif, grâce à des moyens de guidage (12).

## DESCRIPTION DETAILLEE DE L'INVENTION

Pour la mise en oeuvre de la première modalité de l'invention, on peut choisir, comme oxyde de cuivre, soit CuO, soit Cu2O, ledit réactif étant un agent réducteur dans le cas de CuO, ledit réactif étant soit un agent réducteur, soit un agent de dismutation dans le cas de Cu2O.

Ladite dispersion (4) de CuO ou de Cu2O dans un solvant, préparée à l'étape a) du procédé, comprend une fine dispersion de CuO ou de Cu2O en particules de taille moyenne inférieure à 30 µm, et de préférence inférieure à 10 µm, et supérieure à 0,1 µm.

La teneur en CuO ou en Cu2O dans ladite dispersion (4) est comprise entre 20 et 80 %.

Si l'on souhaite obtenir une dispersion fluide, la teneur en Cu2O ou en CuO dans ladite dispersion sera généralement comprise entre 20 et 60 % en poids, mais par ailleurs, la viscosité, qui augmente avec la teneur en Cu2O ou en CuO, dépend aussi des autres constituants de la dispersion.

La formation de Cu à partir de Cu2O peut être réalisée selon deux voies classiques, par action d'un agent réducteur ou par dismutation.

La dismutation (disproportionation en anglais) de Cu2O est, en elle-même, une réaction connue que l'on peut écrire (réaction équilibrée) :

$$2\ Cu^+ \longleftrightarrow Cu^{++} + Cu$$

Il est avantageux selon l'invention de choisir la réaction de dismutation de Cu2O, et de préférence, de choisir comme réactif un agent de dismutation qui soit un acide, pour les raisons suivantes :

- d'une part, l'action d'un acide sur ladite couche mince comprenant du Cu2O est plus rapide que celle d'un agent réducteur : la mobilité (la facilité de pénétration dans ladite couche) des ions $H^+$ est beaucoup plus grande que celle d'un réducteur tel qu'un borohydrure. D'où une possibilité de traitement en continu.
- d'autre part, selon une hypothèse de la demanderesse, il est possible que la pénétration de l'acide dans ladite couche mince comprenant du Cu2O et la réaction de dismutation elle-même entraîne, par la formation d'un ion $Cu^{++}$ soluble en milieu aqueux, une porosité dans ladite couche mince comprenant du Cu qui améliore beaucoup le "contact électrolytique" entre le dépôt de Cu métallique de ladite couche mince comprenant du Cu et toute solution d'ion métallique à déposer.
- enfin, les acides courants sont beaucoup plus économiques que les réducteurs tels que les borohydrures.

Par ailleurs, il est à souligner que, comme cela a été démontré suite aux mesures de résistivité de surface effectuées dans le cadre des recherches de la demanderesse, une surface de faible résistivité n'apparaît plus comme une nécessité pour pouvoir effectuer ensuite, et directement, un dépôt électrolytique. Selon l'invention, il n'est pas nécessaire de chercher à augmenter la quantité de particules conductrices, du moment qu'une résistivité de surface, qui peut être aussi élevée que $40.10^6$ ohm/☐ suffit pour obtenir l'effet technique premier qui permet le dépôt électrolytique subséquent.

Dans le cas d'une dismutation de Cu2O à l'acide, on opère de préférence avec un acide dilué en solution aqueuse. Ledit acide est choisi parmi le groupe formé par les acides acétique, formique, nitrique, oxalique, phosphorique, sulfamique, sulfurique, tartrique. De préférence, on utilise l'acide sulfurique.

Cette réaction de dismutation, qui conduit à la formation de la couche mince (9) comprenant du Cu, est généralement réalisée après séchage et élimination des matières volatiles de la couche mince (5). Cependant, il est important, selon l'invention, que le séchage soit conduit dans des conditions, notamment de température, qui conservent la perméabilité du liant audit réactif. En effet, il faut donc éviter des températures de séchage qui conduiraient à une polymérisation ou une réticulation importante dudit liant.

On a observé, d'une part, que la réaction de dismutation est très rapide, de l'ordre de quelques secondes, typiquement de 5 à 20 secondes, et d'autre part que les couches minces, couches (5a) puis (9), conservent leur intégrité et ne se désagrègent pas durant le séchage, la phase de lavage acide et de rinçage à l'eau, ce qui est essentiel pour la mise en oeuvre de l'invention. Ce sont là deux critères essentiels dans le choix d'un liant et celui des conditions de formation des couches minces (5a) et (9).

Selon l'invention, on peut aussi réaliser la réaction de Cu2O avec un sel, de préférence un sulfure soluble dans l'eau (K2S par exemple). Dans ce cas, il se forme une couche noire sur laquelle on peut effectuer un dépôt par voie électrolytique.

La seconde modalité pratique de l'invention fait appel, comme déjà mentionné, à l'emploi direct de particules conductrices. Dans ce cas, le procédé selon l'invention comprend les étapes suivantes :

a) on prépare une dispersion (4a) d'une poudre conductrice électrique, à l'état divisé, comprenant un solvant et un liant sélectionné,

b) on applique ladite dispersion (4a) sur ledit substrat non-conducteur (1), et on forme une couche mince (9a), sur ledit substrat non-conducteur, comprenant ladite poudre conductrice à l'état divisé,

c) on dépose sur ladite couche (9a) une couche métallique par réduction électrolytique, d'au moins une espèce métallique ionique en solution.

Mais il est à noter que, si l'emploi de particules conductrices électrique est nécessaire, l'obtention d'une surface conductrice, ou d'une surface de basse résitivité - typiquement inférieure à 1000 ohm/☐ - n'est pas nécessaire selon l'invention pour pouvoir réaliser ensuite directement un dépôt électrolytique, en effet une résistivité pouvant atteindre $40.10^6$ ohm/☐ convient selon l'invention, ce qui permet d'utiliser de faibles quantités de poudres conductrices, ou des poudres un peu moins conductrices mais en plus grande quantité.

Ladite poudre conductrice est, de préférence, une poudre de graphite de taille particulaire inférieure à 50 μm, mais toute poudre conductrice, comme par exemple une poudre métallique, pourrait convenir à condition de choisir un métal peu oxydable.

De préférence, ladite poudre de graphite est sous forme de paillettes de 1 à 3 μm d'épaisseur et de 5 à 20 μm comme plus grande dimension.

Quelle que soit la modalité de mise en oeuvre de l'invention, ladite dispersion fluide (4,4a) peut être appliquée sur ledit substrat non-conducteur (1) par enduction, trempage, engobage, pulvérisation ou toute autre méthode connue, notamment dans les techniques de l'imprimerie (sérigraphie, flexographie...) ou celles de la peinture, y compris la peinture industrielle, pour appliquer une dispersion fluide en couche mince et d'épaisseur régulière sur un substrat, et typiquement d'épaisseur inférieure à 30 μm.

Quelle que soit la modalité de l'invention, ledit liant joue sensiblement le même rôle, qu'il s'agisse d'une couche (9) contenant des particules de Cu, ou d'une couche (9a) contenant des particules conductrices.

L'invention permet, à l'étape b) du procédé, d'appliquer ladite dispersion (4) sur ledit substrat non-conducteur (1) à l'aide d'un masque, typiquement par sérigraphie, de manière à obtenir, après l'étape d) du procédé, des pistes métalliques conductrices, de préfence en cuivre.

En général, la dispersion (4,4a), pour être applicable sur un substrat (1), doit présenter une fluidité suffisante, variable selon la technique d'application choisie. Par contre, une fois cette dispersion déposée en couche mince sur le substrat, il est souvent souhaitable de figer cette dispersion, par toute méthode connue pour figer une dispersion, et typiquement, soit en évaporant ledit solvant, soit en floculant ledit liant, soit en appliquant ladite dispersion à chaud (à l'état fluide) puis en refroidissant pour augmenter fortement la viscosité, auquel cas, une élimination de solvant peut ne pas être nécessaire.

Le fait de figer la dispersion revient à augmenter sa cohésion, ainsi que le plus souvent l'adhérence au substrat, ce qui permet une manipulation aisée du substrat revêtu et un traitement par ledit réactif, si nécessaire.

Après avoir formé, directement ou non, une couche (9,9a) contenant des particules conductrices, on procède au dépôt électrolytique de métal.

Selon l'invention le dépôt électrolytique de ladite espèce métallique est, de préférence, effectué, dans un ou plusieurs bains d'électrolyse, en deux temps :

- dans un premier temps, on réalise un dépôt métallique "primaire" sur la surface traitée selon l'invention (soit après les étapes a), b) et c) formant la couche (9) dans le cas où une dispersion (4) de Cu2O est utilisée, soit après les étapes a) et b) formant la couche (9a) dans le cas où une dispersion (4a) de poudre conductrice est utilisée), par croissance et propagation, à partir d'au moins un point de contact électrique sur ladite surface traitée, d'un film métallique jusqu'à ce que, par avance du front de croissance dudit film métallique, ledit film métallique "primaire" (14) recouvre ladite surface traitée, l'épaisseur dudit film métallique "primaire" (14) étant faible et typiquement inférieure à 10 μm,

- dans un deuxième temps, on augmente l'épaisseur $E_i$ dudit film métallique "primaire" jusqu'à obtenir l'épaisseur $E_f$ souhaitée pour ladite couche métallique (11).

Dans ledit premier temps, on obtient ledit film métallique "primaire" (14) en augmentant progressivement l'intensité J, ou la densité I, du courant d'électrolyse jusqu'à obtenir une intensité maximale Jmax(ou une densité Imax) qui, typiquement mais pas obligatoirement, sera celle utilisée lors dudit deuxième temps, et en limitant l'agitation dudit bain d'électrolyse. En pratique, on multiplie les points de contact afin de limiter le temps de formation ($\Delta t_s$) du film métallique "primaire" (14).

Au lieu d'augmenter la densité de courant, on peut aussi utiliser des courants pulsés croissants, ou aussi fixer la tension de dépôt et laisser flotter le courant, qui augmentera alors en proportion de la surface métallisée.

Dans le cas d'une augmentation progressive de densité ou d'intensité (dImax/dt), celle-ci est choisie aussi élevée que possible, mais en-dessous d'une valeur limite déterminable expérimentalement (dImax/dt)$_{max}$ au-delà de laquelle un arrêt de la croissance et de la propagation dudit film métallique (14) a lieu avant que la totalité de ladite surface traitée soit recouverte dudit film métallique.

En effet, la demanderesse a observé qu'une trop forte augmentation d'intensité entraînait un arrêt brusque de la croissance en surface du film métallique (14). L'examen détaillé du phénomène a montré que lorsque la densité de courant est trop grande, il se forme des dépôts "brûlés", c'est à dire que, au front de croissance dudit film métallique, des hydroxydes métalliques s'incorporent audit film et perturbent sa croissance.

Dans le cas d'une métallisation en continu, on utilise deux cuves successives d'électrolyse, comme représenté à la figure 7. Outre la concentration en sel métallique et le choix adapté des paramètres électriques (intensité et tension), la disposition inclinée de la bande support (1) par rapport à la cuve métallique servant d'anode peut contribuer à la formation progressive du film métallique (14) dans le premier bain (10a) d'électrolyse, par augmentation progressive du champ électrique au fur et à mesure de l'avancée de la bande dans le bain (10a).

Dans le cas où le bain (10a) ne comprend qu'un seul point de contact électrique par la cathode (15a), la vitesse d'avance de la bande est réglée sur la vitesse de croissance et propagation du film métallique, qui est typiquement d'au moins quelques centimètres par minute (typiquement 3 à 4 cm/min).

Selon l'invention, ledit liant est à une teneur pondérale dans ladite dispersion (4,4a) inférieure à 20 % en poids, et est choisi de manière,

1) à obtenir, en fonction dudit solvant (liant devant être soluble ou finement dispersable dans ledit solvant), une dispersion (4,4a) stable dudit oxyde de cuivre ou de ladite poudre conductrice,

2) à former une couche mince continue (5,9a) sur ledit substrat, y compris après élimination, partielle ou totale, dudit solvant,

3) à former une couche mince (9,9a) conservant son intégrité dans un bain d'électrolyse.

La première fonction du liant est donc l'aptitude à former une couche mince et continue enrobant des particules, qui ne se désagrège pas au contact de l'eau en particulier.

La deuxième fonction essentielle que doit avoir le liant est son aptitude à permettre la croissance d'un film métallique dans des conditions d'électrolyse. Comme, d'une part, il semble difficile, sinon impossible de corréler cette fonction à une propriété intrinsèque du liant, et comme d'autre part, comme cela sera ensuite expliqué plus en détail, cette aptitude dépend aussi de la texture de surface du substrat (1) à traiter.

Pour toutes ces raisons, ledit liant est sélectionné sur la base d'un test comprenant les étapes a) à d) dudit procédé comprenant la formation d'une couche mince (9) comprenant des particules de cuivre, dans lequel les paramètres autres que ceux relatifs au liant et à son solvant sont prédéterminés :

- à l'étape a), on prépare ladite dispersion (4) qui contient, en poids, 50 % de Cu2O, et sensiblement 10 % dudit liant à tester et 40 % de son solvant,

- à l'étape b), on applique ladite dispersion (4) sur une plaque du matériau isolant (1) à métalliser (10 cm x 20 cm x 1 cm) une couche (5) de 25 μm d'épaisseur et on forme une couche mince (5a) en éliminant le solvant à une température suffisamment basse pour ne pas polymériser ou réticuler ledit liant, dans le cas d'un liant polymérisable ou réticulable thermiquement.

- à l'étape c), on traite ladite plaque recouverte de la dispersion de Cu2O par de l'acide sulfurique à 10 % en poids pendant 1 minute pour réaliser la dismutation de Cu2O et former une couche mince (9) contenant des particules de Cu, puis on rince la plaque à l'eau.

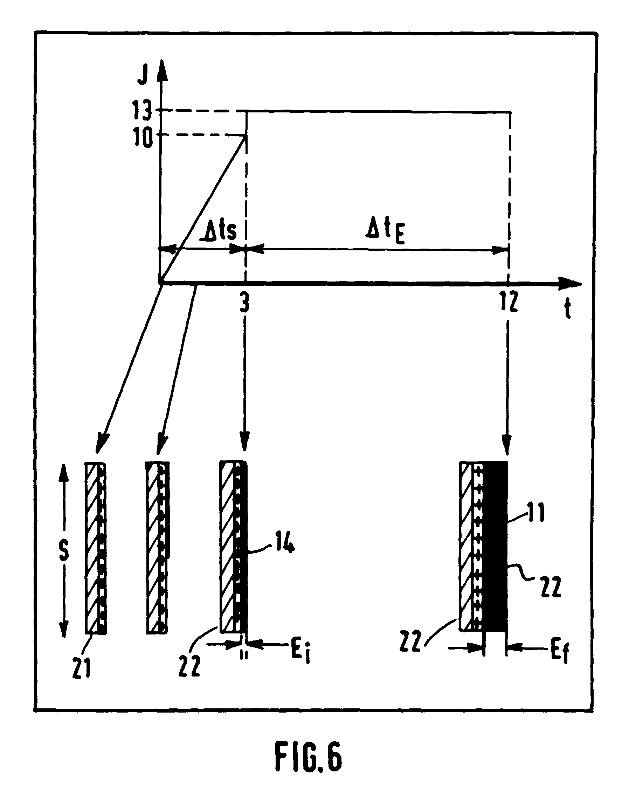

- à l'étape d), on soumet la plaque obtenue à l'issue de l'étape c) à un test de dépôt électrolytique de Cu, dans les conditions de formation de ladite couche métallique "primaire" (14) avec une rampe de courant typiquement comme indiqué à la figure 6 où $\Delta t_s$ vaut 3 min et l'intensité de courant J vaut 10A.

On sélectionne ledit liant si, par croissance et propagation d'un film métallique, il se forme progressivement un film métallique "primaire" (14) recouvrant ladite couche mince (9). Voir exemple 3.

Dans le cas où le matériau testé sera très divisé (mousse à porosité ouverte), $\Delta t_S$ sera notablement augmenté pour atteindre par exemple 15 min. Voir exemple 4.

La demanderesse a observé que tous les liants sélectionnés en utilisant un substrat (1) plan, par exemple une plaquette de matière plastique, ne convenaient pas pour un substrat (1) constitué d'une mousse à porosité ouverte, alors que tous les liants qui conviennent pour un substrat poreux conviennent aussi pour un substrat non poreux.

Selon une hypothèse de la demanderesse, seuls les liants les plus "souples" seraient adaptés à des substrats poreux, qui comprennent des surfaces internes présentant soit des faibles rayons de courbures, soit de nombreuses ruptures de pentes.

De préférence, ledit solvant est choisi parmi les solvants organiques, et ledit liant est, de préférence, choisi parmi les oligomères, prépolymères ou polymères de poids moléculaire réduit, ayant des groupements polaires.

On peut choisir ledit liant parmi les résines thermoplastiques (acéto-butyrates de cellulose, acryliques, polyamides, polystyrène, vinylisobutyléthers....), les résines thermodurcissables avant réticulation (résines silicones, les résines époxydes, phénoxy, polyesters...).

Ledit liant est choisi, de préférence, parmi les résines silicones.

Ces liants peuvent être choisis parmi les adjuvants connus pour stabiliser les pigments minéraux des encres ou des peintures, le plus souvent, mais pas exclusivement, en milieu solvant organique. Ces agents stabilisants, d'une grande variété chimique, sont des molécules dont une partie présente une affinité pour le produit à disperser, et dont l'autre partie peut avoir une affinité pour le solvant.

Ces agents stabilisants, qui peuvent être aussi des monomères, oligomères ou polymères à poids moléculaire bas à moyen, peuvent être choisis également en fonction du substrat (1) et de la nature du produit que l'on souhaite fabriquer.

En effet, il est des cas où l'on souhaite fabriquer un composite (24) "substrat (1) + couche métallique (11) adhérente au substrat", et il est des cas, comme représenté à la figure 7, où on souhaite fabriquer une bande métallique (13,23) et où, contrairement au cas précédent, on souhaite pouvoir séparer aisément ladite couche métallique (11) de son substrat (1) pour obtenir une bande métallique (13,23).

Dans le premier cas, il sera recherché une affinité, une compatibilité entre la nature chimique du substrat et celle du liant de manière à ce qu'une certaine liaison entre le substrat (1) et la couche (5) s'opère durant la phase d'élimination du solvant et surtout lors d'un traitement de réticulation dudit liant postérieur au dépôt de métal par électrolyse.

Dans le second cas, au contraire, il sera recherché une incompatibilité chimique.

Mais dans tous les cas, le liant sélectionné devra permettre une perméabilité audit réactif et audit bain d'électrolyse, en particulier une migration rapides des ions H$^+$ dans le cas du procédé préféré de dismutation de Cu2O, tout en conservant son intégrité physique en présence dudit réactif.

La formulation de ladite dispersion (4) peut aussi faire appel à divers additifs (agents épaississants qui peuvent être par exemple du type cellulose modifiée, aluminosilicates du type montmorillonite, Bentone ® modifiée, Thixcin ® = dérivé de l'huile de ricin), connus en eux-mêmes dans le domaine des peintures et des encres, notamment pour adapter les propriétés rhéologiques de la dispersion à la technique d'application choisie, ou pour assurer la conservation au cours du temps de ladite dispersion. Généralement, ces additifs sont utilisés en faible quantité (typiquement de l'ordre de 1% en poids).

Selon l'invention, ledit substrat non-conducteur (1) est choisi parmi le groupe formé par les matériaux plans (films plastiques en bobine, tissus, non-tissés, feutres, de préférence en bobines, etc...), les matériaux de forme (pièces de forme, tubes, etc...), les matériaux cellulaires à porosité ouverte (mousses en matière plastique, feutres en matière textile, etc...).

L'invention ne connaît pas de limitation quant à la nature et l'état plus ou moins divisé dudit substrat non-conducteur (1) (plastique, céramique, verre, bois, textile, etc...), si ce n'est que ce substrat (1) ne doit pas être détruit durant la mise en oeuvre du procédé selon l'invention, que ce soit par le solvant de ladite dispersion, ou que ce soit par l'eau dudit bain d'électrolyse.

Ledit substrat (1) peut être un matériau en bande ou en formats et dans lequel les différentes étapes dudit procédé de fabrication peuvent être effectuées en continu, comme illustré à la figure 7 à titre d'exemple.

Après formation de la couche métallique (11), le procédé permet de nombreuses variantes selon la nature du matériau final recherché :

A l'issue de l'étape de formation de ladite couche métallique (11), on peut séparer ladite couche métallique (11) dudit substrat non-conducteur (1), de préférence par séparation physique, pyrolyse ou dissolution chimique. On obtient ainsi un matériau (13, 23) essentiellement métallique.

On peut aussi, à l'issue de l'étape de formation de ladite couche métallique (11), ne pas séparer ladite couche métallique (11) dudit substrat non-conducteur (1), et renforcer éventuellement l'adhérence entre ledit substrat non-conducteur (1) et ladite couche métallique (11) en polymérisant ou réticulant ledit liant après formation de ladite couche métallique (11).

EXEMPLE 1

On a préparé au broyeur à billes une dispersion (4) ayant la composition pondérale suivante :

- Cu2O : 50 %
- liant ou agent stabilisant : 10 %
- solvant : 40 %

Le Cu2O est une poudre du commerce, qui après broyage, présente une taille particulaire moyenne de l'ordre de 2 μm. Le liant (agent stabilisant) est une résine silicone méthylphényle du commerce, et le solvant est du trichloréthylène.

Le substrat est un morceau de mousse de polyuréthane de 10 mm d'épaisseur, à pores ouverts (pores de 0,8 à 1 mm). On a trempé le substrat dans la dispersion (4), puis, après l'avoir retiré et égoutté, on l'a séché à l'air sec pendant une minute.

On l'a ensuite trempé pendant une dizaine de secondes dans une solution d'acide sulfurique à 10 %, puis on l'a rincé à l'eau.

On a placé ce substrat dans un bain d'électrolyse classique contenant 80 g/l de CuSO4, et on l'a connecté au pôle négatif d'un générateur de courant. On a soumis ce substrat à une électrolyse avec une densité I de courant égale à 3 A/dm$^2$, pendant une durée de 20 minutes, de manière à obtenir un film métallique (14) de cuivre d'une épaisseur moyenne de l'ordre de 10 μm.

EXEMPLE 2

Cet exemple est semblable à l'exemple 1, sauf en ce que le réactif n'est pas l'acide sulfurique mais une solution aqueuse à 3% en poids de sulfure de potassium.

On a ainsi obtenu un dépôt noir conducteur qui permet, par électrolyse d'un sel de cuivre, d'obtenir un dépôt de cuivre.

EXEMPLE 3

Dans cet exemple, on a testé 11 liants différents.

A) Préparation des dispersions de Cu2O par broyage, comme à l'exemple 1, de poudre de Cu2O (50% en poids de la dispersion) dans le trichloréthylène comme solvant en présence de liant. Le tableau qui suit indique la nature du liant et le pourcentage pondéral de liant et de solvant dans la dispersion:

| | LIANT | SOLVANT |
|---|---|---|
| Nature chimique / Nom commercial | % pondéral | % pondéral |
| 1) polyméthylphényle silicone/NH2246 (R) | 10 | 40 |
| 2) polyméthylphényle silicone/RHODORSIL 1505 (R) | 10 | 40 |
| 3) polyméthylphényle silicone /REN50 (R) | 10 | 40 |
| 4) polyméthylphényle silicone /RHODORSYL 6405 | 10 | 40 |
| 5) Silicone /SR125 (R) | 10 | 40 |
| 6) Silicone /DOW CORNING 808 (R) | 10 | 40 |
| 7) Polyméthacrylate /ALTUGLAS (R) | 10 | 40 |
| 8) Acrylique /PERLUCID Re2600 (R) | 10 | 40 |

(suite)

| | LIANT | SOLVANT |
|---|---|---|
| Nature chimique / Nom commercial | % pondéral | % pondéral |
| 9) Epoxyde /DURALIT R-1516 (R) | 10 | 40 |
| 10) Polystyrène (à partir de poystyrène expansé du commerce) | 1 | 49 |
| 11) Acétobutyrate de cellulose | 0,8 | 49,2 |

Les fournisseurs de ces liants sont dans l'ordre respectif, les sociétés : 1) HüLL, 2) RHONE-POULENC, 3) WACKER, 4) RHONE-PULENC, 5) G.E. SILICONE, 6) DOW CHEMICAL, 7) ALTULOR, 8) et 9) LA CELLIOSE, 11) EASTMAN

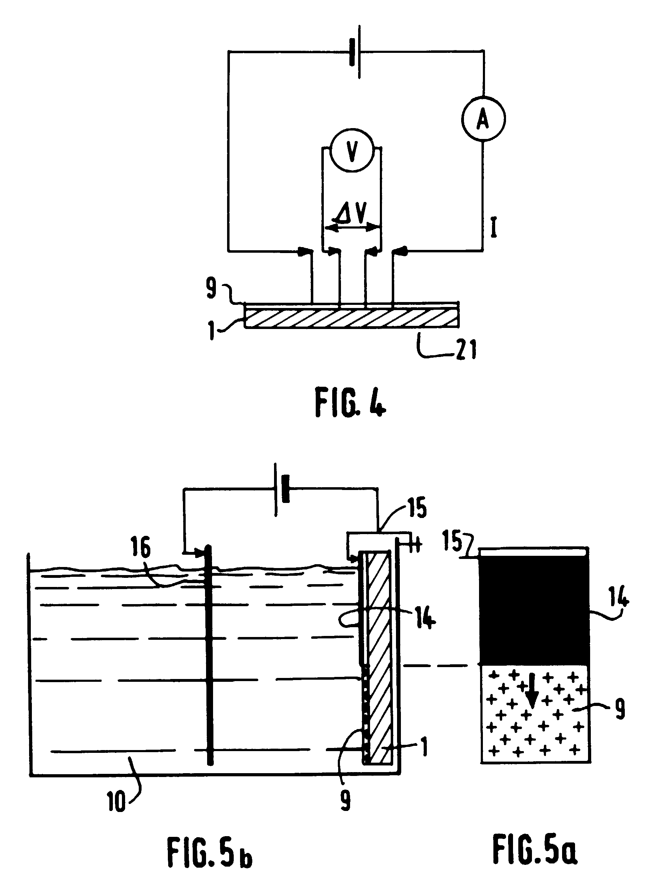

B) Application sur un substrat (1) :
Le substrat est une plaque de téflon de dimensions 143x76x3 (mm).
On a appliqué chaque dispersion au trempé dans la dispersion, ce qui a conduit à la formation d'une couche humide (5) d'environ 30-40 μm.
Après séchage à l'air, on a obtenu une couche sèche (5a) d'environ 20 μm d'épaisseur. On a éliminé les 5 couches latérales pour ne conserver qu'une couche de dimensions 143mm x76mm sur le substrat.
C) Dismutation de Cu2O :
On a trempé les 11 plaques dans une solution d'acide sulfurique à 10% en poids, pendant 1 min, puis, après rinçage à l'eau, on a séché les plaques à l'air comprimé.
D) Mesure de la résistivité de surface :
On a utilisé pour cela la mesure à quatre points illustrée à la figure 4.
La mesure revient à mesurer la tension Δv à l'aide d'un voltmètre, et l'intensité I, alors que le générateur électrique impose une tension de 100 V.
Les valeurs obtenues, en ohm/□, sont indiquées dans le tableau sous E).
E) Formation d'un film de cuivre (14) par dépôt électrolytique comme illustré aux figures 5 et 5a.
Le bain d'électrolyse a comme composition :

- Cu(BF4)2 : 450 g/l
- HBF4 : 40 g/l

Conditions d'électrolyse :

- générateur électrique = générateur de courant pulsé
- température du bain = 20 - 25°C
- J passant de IA au début de l'électrolyse pour atteindre 10A au bout de 3 min. Puis, une valeur de 13A a été maintenue pendant 12 minutes.

On a observé dans tous les cas la formation d'un film métallique (14) par propagation et croissance progressive du film métallique depuis le point de contact électrique. La vitesse de propagation a été sensiblement la même pour tous les liants et voisine de 50mm/min. Ce film métallique intermédaire (14) a une épaisseur de l'ordre de 6 μm.
Sur le tableau qui suit, on a indiqué la quantité de cuivre déposée sur chaque échantillon, la quantité théorique (dépôt sur plaque de cuivre) étant de 3,376 g, et avec, en regard, la résistivité de surface :

| LIANT | QUANTITE Cu | RESISTIVITE |
|---|---|---|
| Nature chimique / Nom commercial | (g) | $10^6$ohm/□ |
| 1) polyméthylphényle silicone/NH2246 (R) | 3,00 | 21,7 |
| 2) polyméthylphényle silicone/RHODORSIL 1505 (R) | 2,68 | 15,5 |
| 3) polyméthylphényle silicone /REN50 (R) | 2,85 | 34,5 |
| 4) polyméthylphényle silicone /RHODORSYL 6405 | 3,06 | 29 |
| 5) Silicone /SR125 (R) | 2,93 | 1,7 |
| 6) Silicone /DOW CORNING 808 (R) | 2,95 | 1,5 |
| 7) Polyméthacrylate /ALTUGLAS (R) | 2,93 | 2,2 |
| 8) Acrylique /PERLUCID Re2600 (R) | 2,95 | 23 |

(suite)

| LIANT | | QUANTITE Cu | RESISTIVITE |
|---|---|---|---|
| Nature chimique / Nom commercial | | (g) | $10^6$ohm/□ |
| 9) Epoxyde /DURALIT R-1516 (R) | | 3,17 | 39,5 |
| 10) Polystyrène | | 2,77 | 1,1 |
| 11) Acétobutyrate de cellulose | | 2,90 | 8 |

En conclusion, on peut noter d'une part qu'il ne semble pas y avoir de corrélation entre la résistivité de surface et la quantité de cuivre déposée, qui, dans tous les cas, n'est pas éloignée de la quantité théorique, ce qui montre que tous les liants testés sont aptes pour la mise en oeuvre de l'invention dans le cas du substrat utilisé.

EXEMPLE 4

On a refait la même série d'essais que celle de l'exemple 3, mais en prenant comme substrat une plaque en mousse de polyuréthane de dimensions 245x55x10 mm$^3$.
Les seules différences par rapport à l'exemple 3 sont les suivantes :

- dismutation du Cu2O en 3 minutes, au lieu de 1 minute à l'exemple 3,
- J passant de 2A au début de l'électrolyse pour atteindre 30A au bout de 15 min ($\Delta t_S$). Puis, une valeur de 35A a été maintenue pendant 15 minutes ($\Delta t_E$).

On a mesuré le temps (min) nécessaire pour le recouvrement total de la surface (245mmx55mm), la fraction (%) de la distance parcourue par le film métallique (taux de recouvrement de la surface de la plaque), et la masse (g) de cuivre déposée :

| LIANT | TEMPS | FRACTION | MASSE |
|---|---|---|---|
| Nature chimique /  Nom commercial | (min) | % | (g) |
| 1) polyméthylphényle silicone/ NH2246 (R) | 15 | 100 | 9 |
| 2) polyméthylphényle silicone/ RHODORSIL 1505 (R) | 20 | 100 | 7,6 |
| 3) polyméthylphényle silicone / REN50 (R) | 14,5 | 100 | 9 |
| 4) polyméthylphényle silicone / RHODORSYL 6405 | 17 | 100 | 8,6 |
| 5) Silicone / SR125 (R) | 17 | 100 | 6,8 |
| 6) Silicone / DOW CORNING 808 (R) | 17 | 100 | 3,1 |
| 7) Polyméthacrylate / ALTUGLAS (R) | – | 61 | 1,3 |
| 8) Acrylique / PERLUCID Re2600 (R) | – | 0 | 0 |

| | | | |
|---|---|---|---|
| 9) Epoxyde / DURALIT R-1516 (R) | – | O | O |
| 10) Polystyrène | – | 53 | 5,7 |
| 11) Acétobutyrate de cellulose | – | 32 | 1,1 |

Ce tableau montre, dans le cas d'un substrat en mousse à porosité ouverte, la grande sélectivité du test de sélection des liants.

La demanderesse a émis l'hypothèse selon laquelle, la nonpropagation du film métallique serait due à la discontinuité de la couche mince (9,9a) contenant des particules conductrices, discontinuité qui résulterait elle-même d'une moins grande souplesse du liant (faïencage de la couche lors du séchage de la dispersion ?).

A noter que, dans le cas d'un support à porosité ouverte, des coupes sur le produit final ont montré la continuité du film métallique (14) sur l'ensemble de la surface interne des pores, puis celle de la couche métallique (11) finale.

EXEMPLE 5

On a réalisé une série d'essais conduits comme à l'exemple 4 et avec le liant 1), mais qui diffèrent par les conditions d'électrolyse en faisant varier $\Delta t_S$ : J est passé de 2A au début de l'électrolyse pour atteindre 30A au bout d'un temps $\Delta t_S$. Puis, une valeur de 35A a été maintenue pendant un temps $\Delta t_E$ égal à 30 min.

On a obtenu les résultats suivants, exprimés par le temps nécessaire au recouvrement complet du substrat en mousse:

| ESSAIS | $\Delta t_S$ (min) | temps de recouvrement complet (min) |
|---|---|---|
| 5a | O | Pas de recouvrement |
| 5b | 7 | Recouvrement partiel |
| 5c | 8 | 8 |
| 5d | 10 | 10 |
| 5e | 12 | 12 |
| 5f | 15 | 13 |
| 5g | 20 | 15 |
| 5h | 25 | 16 |

Pour les essais 5c à 5h, l'épaisseur finale de la couche métallique (11) était voisine de 50 µm.

Ces essais montrent clairement qu'il y a un seuil à ne pas dépasser pour la vitesse de montée en densité de courant. Dans le cas présent, il faut que la vitesse de montée soit inférieure à 35 A pour 7 min, sinon la propagation du film métallique s'arrête en cours d'électrolyse, ou même ne se produit pas du tout, comme dans l'essai 5a.

il est à noter que, du point de vue de la productivité, il faut se placer juste en-dessous de ce seuil (essai 5c).

EXEMPLE 6

On a réalisé une série d'essais conduits comme à l'exemple 4 et avec le liant 1), mais qui diffèrent par la réticulation plus ou moins grande du liant :

essai 6a = essai 4-1 dans lequel la dispersion (4) comprenant ledit liant, après application sur le substrat (1) en couche (5), est séchée à l'air pour former le matériau (20) comprenant une couche (5a).

essai 6b = essai 6a, sauf que la couche (5) est séchée, non pas sensiblement à la température ambiante, mais à 130°C pendant 4 h.

essai 6c = essai 6a, sauf que la couche (5) est séchée à 200°C pendant 30 min.

Résultats obtenus :

L'essai 6a est égal à l'essai 4-1, et conduit à une dépôt uniforme de film métallique (14) en 15 minutes, puis à une couche métallique épaisse (11).

Dans le cas de l'essai 6b, seulement les 2/3 de la plaque de mousse ont été recouverts d'un dépôt métallique, même au bout de 1 heure d'électrolyse.

Dans l'essai 6c, il ne s'est formé aucun dépôt métallique, même au bout de 1 heure d'électrolyse.

Ces essais confirment l'importance décisive de l'absence de réticulation du liant.

EXEMPLE 7

Dans l'essai 7a, on a reproduit les conditions de l'essai 6c, sauf en ce que le substrat choisi était une plaque de verre (120 mm x 60 mm x 2 mm), au lieu d'être un plaque de mousse polyuréthane.

Dans l'essai 7b, on a reproduit les conditions de l'essai 7a, sauf en ce que, après cuisson à 200°C, on a abrasé la surface de la couche (5a) avant de traiter la plaque par l'acide sulfurique dilué pour dismuter la poudre de Cu2O.

Résultats :

Dans l'essai 7a, comme dans l'essai 6c, il ne se forme aucun dépôt de cuivre par électrolyse.

Dans l'essai 7b, il se forme un film métallique (14) qui recouvre la totalité de la plaque sur 120 mm en 8 minutes ($\Delta t_S$). Ces essais confirment les résultats des essais de l'exemple 6 et montrent qu'il est essentiel que le liant, par sa nature chimique et/ou son état plus au moins réticulé, ne puisse soustraire les particules de Cu2O à l'action dismutante de l'acide sulfurique.

D'autre essais conduits avec des poudres conductrices, ont abouti aux mêmes conclusions, à savoir la nécessité d'obtenir une couche (9,9a) contenant des particules conductrices non isolées du bain d'électrolyse.

OBJETS COMPLEMENTAIRES DE L'INVENTION

L'invention a comme objets complémentaires les divers produits que permet d'obtenir le procédé selon l'invention. Ces produits peuvent être de trois types :

a) soit un matériau (22a) comprenant la combinaison d'un substrat isolant (1) et d'un film métallique (14) de faible épaisseur, typiquement inférieure à 10 µm,

b) soit un matériau (24) composite comprenant la combinaison étroite d'un substrat isolant (1) et d'une couche métallique (11) d'épaisseur supérieure à 10 µm, le substrat pouvant être quelconque (film plastique, mousse poreuse, tissu, verre, etc...),

c) soit un matériau (23) comprenant essentiellement une couche métallique (11).

Dans chacun de ces types de produits, la couche métallique (11) peut comprendre des couches métalliques de différents métaux.

APPLICATIONS DE L'INVENTION

L'invention trouve de nombreuses applications parmi lesquelles on peut citer :

- la fabrication de feuilles minces métalliques (feuilles de nickel, de cuivre, de nickel/cuivre, etc...),
- la fabrication de supports pour catalyseurs qui nécessitent un rapport surface/volume élevé, en partant, comme à l'exemple 4 d'un substrat à porosité ouverte ayant lui-même un rapport surface/volume élevé, et en éliminant éventuellement, après dépôt de la couche métallique, le substrat initial,
- la fabrication des pistes conductrices (Cu de préférence) adhérentes à un substrat isolant pour l'instrumentation, par exemple pour la fabrication de capteurs de force,
- la fabrication de structures poreuses (avec Cu de préférence) utilisées pour les échangeurs thermiques,
- la fabrication d'électrodes métalliques poreuses pour accumulateurs, ou celle de supports pour les électrodes d'accumulateurs, qui peuvent être recouverts de métaux tels que le cadmium, le nickel, le cuivre, etc...
- l'antiparasitage de substrats non-conducteurs, rigides ou souples,
- le traitement antistatique de substrats non-conducteurs, rigides ou souples (y compris les tissus).

AVANTAGES DE L'INVENTION

L'invention, comme cela a été démontré, résout de nombreux problèmes rencontrés avec les procédés de l'art antérieur puisque le procédé selon l'invention est :

a) applicable, sans limitations connues, à tout type de support, le traitement selon l'invention revenant en quelque sorte à appliquer une "peinture" sur un substrat isolant quelconque (objet massif, film, mousse, tissus, etc...)

b) d'une grande souplesse, par la possibilité d'obtenir un large éventail de produits finals, par combinaisons de substrats divers et de couches métalliques en utilisant sensiblement les mêmes outils de production.

c) économique en matières consommables et en coûts de fabrication en permettant tout dépôt électrolytique sans faire appel à des réactifs coûteux ou à des étapes de traitement spécifiques.

d) économique en investissement, les dépôts étant effectués à l'aide de moyens traditionnels (sans avoir à faire appel à des techniques sous vide et/ou à haute température).

e) de grande productivité, par la possibilité de former un dépôt électrolytique sur un substrat de grande largeur (1 à 2 m) en continu.

**Revendications**

1. Procédé de fabrication d'un dépôt métallique continu (11) sur un substrat non-conducteur (1) comprenant les étapes suivantes :

a) on prépare une dispersion (4) d'un oxyde de cuivre à l'état divisé, apte à être transformé, au moins en partie, à l'état de cuivre métallique par l'action d'un réactif, comprenant un solvant et un liant sélectionné pour former, après élimination du solvant, un film perméable audit réactif et audit bain d'électrolyse de l'étape d),

b) on applique ladite dispersion sur ledit substrat non-conducteur (1), et on forme une couche mince (5), sur ledit substrat non-conducteur, comprenant ledit oxyde de cuivre à l'état divisé,

c) on forme du Cu à partir dudit oxyde de cuivre par action dudit réactif, de manière à obtenir à la surface du substrat non-conducteur une couche mince (9) comprenant du Cu,

d) on dépose directement, sans étape intermédiaire, sur ladite couche (9) comprenant du Cu, une couche métallique par dépôt électrolytique à partir d'un bain d'électrolyse.

2. Procédé selon la revendication 1 dans lequel ledit oxyde de cuivre est soit du CuO soit du Cu2O, ledit réactif étant un agent réducteur dans le cas de CuO, ledit réactif étant soit un agent réducteur, soit un agent de dismutation dans le cas de Cu2O.

3. Procédé selon la revendication 2 dans lequel ladite dispersion (4) de CuO ou de Cu2O dans un solvant, préparée à l'étape a) du procédé, comprend une fine dispersion de CuO ou de Cu2O en particules de taille moyenne inférieure à 30 µm, et de préférence inférieure à 10 µm.

4. Procédé selon la revendication 3 dans lequel la teneur en CuO ou en Cu2O dans ladite dispersion (4) est comprise entre 20 et 80 %.

5. Procédé selon la revendication 4 dans lequel, de préférence, ledit oxyde de cuivre est Cu2O et ledit réactif est un agent de dismutation.

6. Procédé selon la revendication 5 dans lequel ledit agent de dismutation est choisi parmi le groupe formé par les acides acétique, formique, nitrique, oxalique, phosphorique, sulfamique, sulfurique, tartrique.

7. Procédé selon la revendication 4 dans lequel on fait réagir Cu2O avec un sel, de préférence un sulfure soluble dans l'eau.

8. Procédé de fabrication d'un dépôt métallique continu (11) sur un substrat non-conducteur (1) comprenant les étapes suivantes :

a) on prépare une dispersion (4a) d'une poudre conductrice électrique, à l'état divisé, comprenant un solvant et un liant sélectionné pour former, après élimination du solvant, un film perméable audit réactif et audit bain d'électrolyse de l'étape c),

b) on applique ladite dispersion (4a) sur ledit substrat non-conducteur (1), et on forme une couche mince (9a), sur ledit substrat non-conducteur, comprenant ladite poudre conductrice à l'état divisé,

c) on dépose directement, sans étape intermédiaire, sur ladite couche (9a) comprenant du Cu, une couche métallique par dépôt électrolytique à partir d'un bain d'électrolyse.

9. Procédé selon la revendication 8 dans lequel ladite poudre conductrice est, de préférence, une poudre de graphite de taille particulaire inférieure à 50 µm.

10. Procédé selon une quelconque des revendications 1 à 9 dans lequel, à l'étape b) du procédé, on applique ladite dispersion (4,4a) fluide sur ledit substrat non-conducteur (1) par enduction, trempage, engobage, pulvérisation ou toute autre méthode connue, notamment dans les techniques de l'imprimerie (sérigraphie, flexographie...) ou celles de la peinture, y compris la peinture industrielle, pour appliquer une dispersion en couche mince, d'épaisseur inférieure à 30 pm, sur un substrat.

11. Procédé selon la revendications 10 dans lequel, à l'étape b) du procédé, on applique ladite dispersion (4,4a) sur ledit substrat non-conducteur (1) à l'aide d'un masque, typiquement par sérigraphie, de manière à obtenir après dépôt électrolutique, des pistes métalliques conductrices, de préférence en cuivre.

12. Procédé selon une quelconque des revendication 10 et 11 dans lequel, à l'étape b) dudit procédé, après application de ladite dispersion (4,4a) sur ledit substrat, on forme ladite couche mince (5,9a) par toute méthode connue pour figer une dispersion, et typiquement, soit en évaporant ledit solvant, soit en floculant ledit liant, soit en appliquant ladite dispersion à chaud puis en refroidissant, etc...

13. Procédé selon une quelconque des revendications 1 à 12 dans lequel, le dépôt électrolytique de ladite espèce métallique est, de préférence, effectué, dans un ou plusieurs bains d'électrolyse, en deux temps :

- dans un premier temps, on réalise un dépôt métallique "primaire" sur la surface traitée selon l'invention (surface obtenue après les étapes a), b) et c) dans le cas où une dispersion de Cu2O est utilisée, ou après les étapes a) et b) dans le cas où une dispersion de poudre conductrice est utilisée), par croissance et propagation, à partir d'au moins un point de contact électrique de l'électrode et de ladite surface traitée, d'un film métallique jusqu'à ce que, par avance du front de croissance dudit film métallique, ledit film métallique "primaire" recouvre ladite surface traitée, l'épaisseur dudit film métallique étant faible et typiquement inférieure à 10 µm,
- dans un deuxième temps, on augmente l'épaisseur dudit film métallique "primaire" jusqu'à obtenir l'épaisseur souhaitée pour ledit dépôt métallique.

14. Procédé selon la revendication 13 dans lequel, dans un premier temps, on obtient ledit film métallique "primaire" en augmentant progressivement l'intensité du courant d'électrolyse jusqu'à obtenir une intensité maximale Imax qui, typiquement, sera celle utilisée lors dudit deuxième temps, et en limitant l'agitation dudit bain d'électrolyse.

15. Procédé selon la revendication 14 dans lequel l'augmentation progressive d'intensité (dImax/dt) est choisie aussi élevée que possible, mais en-dessous d'une valeur limite déterminable expérimentalement $(dImax/dt)_{max}$ au-delà de laquelle un arrêt de la croissance et de la propagation dudit film a lieu avant que la totalité de ladite surface traitée soit recouverte dudit film métallique.

16. Procédé selon une quelconque des revendications 1 à 15 dans lequel ledit liant est à une teneur pondérale dans ladite dispersion (4) inférieure à 20 % en poids, et est choisi de manière, 1) à obtenir, en fonction dudit solvant (liant devant être soluble ou finement dispersable dans ledit solvant), une dispersion (4) stable dudit oxyde de cuivre ou de ladite poudre conductrice, 2) à former une couche mince continue (5,9a) sur ledit substrat, y compris après élimination, partielle ou totale, dudit solvant, 3) à former une couche mince (9,9a) conservant son intégrité dans un bain d'électrolyse.

17. Procédé selon la revendication 16 dans lequel ledit liant est sélectionné sur la base d'un test comprenant les étapes a) à d) dudit procédé comprenant la formation d'une couche mince (9) comprenant ledit oxyde de cuivre, dans lequel les paramètres autres que ceux relatifs au liant et à son solvant ont été prédéterminés :

à l'étape a), on prépare ladite dispersion (4) qui contient, en poids, 50 % de Cu2O, et sensiblement 10 % dudit liant à tester et 40 % de son solvant,

à l'étape b), on applique ladite dispersion (4) sur une plaque du matériau isolant (1) à métalliser (10 cm x 20 cm x 1 cm) une couche (5) de 25 µm d'épaisseur et on forme une couche mince (5a) en éliminant le solvant à une température suffisamment basse pour ne pas polymériser ou réticuler ledit liant, dans le cas d'un liant polymérisable ou réticulable thermiquement.

à l'étape c), on traite ladite plaque recouverte de la dispersion de Cu2O par de l'acide sulfurique à 10 % en poids pendant 1 minute pour réaliser la dismutation de Cu2O et former une couche mince (9) contenant des particules de Cu, puis on rince la plaque àl'eau.

à l'étape d), on soumet la plaque obtenue à l'issue de l'étape c) à un test de dépôt électrolytique de Cu, dans les conditions de formation de ladite couche métallique "primaire", et on sélectionne ledit liant si, par croissance et propagation d'un film métallique, il se forme progressivement un film métallique "primaire" recouvrant la totalité de ladite couche mince (9).

18. Procédé selon une quelconque des revendications 16 ou 17 dans lequel ledit solvant est choisi de préférence parmi les solvants organiques, et ledit liant est, de préférence, choisi parmi les oligomères, prépolymères ou polymères de poids moléculaire réduit, ayant des groupements polaires.

19. Procédé selon une quelconque des revendications 16 ou 17 dans lequel ledit liant est choisi parmi les résines thermoplastiques (acéto-butyrates de cellulose, acryliques, polyamides, polystyrène, vinylisobutyléthers....), les résines thermodurcissables avant réticulation (résines silicones, les résines époxydes, phénoxy, polyesters...).

20. Procédé selon la revendication 19 dans lequel, ledit liant est choisi, de préférence, parmi les résines silicones.

21. Procédé selon une quelconque des revendications 1 à 20 dans lequel ledit substrat non-conducteur (1) est choisi parmi le groupe formé par les matériaux plans (films plastiques en bobine, tissus, non-tissés, feutres en bobines, etc...), les matériaux de forme (pièces de forme, tubes, etc...), les matériaux cellulaires à porosité ouverte (mousses en matière plastique, feutres en matière textile, etc...).

22. Procédé selon la revendication 21 dans lequel ledit substrat (1) est un matériau en bande ou en formats et dans lequel les étapes dudit procédé sont effectuées en continu.

23. Procédé selon une quelconque des revendications 1 à 22 dans lequel, à l'issue de l'étape de formation de ladite couche métallique (11), on sépare ladite couche métallique (11) dudit substrat non-conducteur (1), de préférence par séparation physique, pyrolyse ou dissolution chimique.

24. Procédé selon une quelconque des revendications 1 à 22 dans lequel, à l'issue de l'étape de formation de ladite couche métallique (11), on ne sépare pas ladite couche métallique (11) dudit substrat non-conducteur (1), et on renforce éventuellement l'adhérence entre ledit substrat non-conducteur (1) et ladite couche métallique (11) en polymérisant ou réticulant ledit liant après formation de ladite couche métallique (11).

**Patentansprüche**

1. Verfahren zur Herstellung einer durchgehenden Metallabscheidung (11) auf einem nichtleitenden Substrat (1), das die folgenden Schritte aufweist:

a) man stellt eine Dispersion (4) eines Kupferoxids im Teilchenzustand, das sich wenigstens zum Teil zur Umwandlung in den Zustand metallischen Kupfers durch die Wirkung eines Reagens' eignet, her, die ein Lösungsmittel und ein Bindemittel aufweist, das zur Bildung eines für das Reagens und das Elektrolysebad des Schritts d) durchlässigen Films nach Beseitigung des Lösungsmittels ausgewählt wird,

b) man bringt diese Dispersion auf das nichtleitende Substrat (1) auf und bildet auf dem nichtleitenden Substrat eine dünne Schicht (5), die das Kupferoxid im Teilchenzustand aufweist,

c) man bildet aus dem Kupferoxid durch Wirkung des Reagens' Cu derart, daß man auf der Oberfläche des nichtleitenden Substrats eine dünne, Cu aufweisende Schicht (9) erhält,

d) man scheidet direkt ohne Zwischenschritt auf der Cu aufweisenden Schicht (9) durch elektrolytische Abscheidung aus einem Elektrolysebad eine Metallschicht auf der Schicht (9) ab.

**2.** Verfahren nach dem Anspruch 1, bei dem das Kupferoxid CuO oder $Cu_2O$ ist, wobei das Reagens im Fall von CuO ein Reduktionsmittel ist und das Reagens im Fall von $Cu_2O$ ein Reduktionsmittel oder ein Dismutationsmittel ist.

**3.** Verfahren nach dem Anspruch 2, bei dem die Dispersion (4) von CuO oder $Cu_2O$ in einem Lösungsmittel, die im Schritt a) des Verfahrens hergestellt wird, eine feine Dispersion von CuO oder $Cu_2O$ als Teilchen mittlerer Größe unter 30 μm und vorzugsweise unter 10 μm darstellt.

**4.** Verfahren nach dem Anspruch 3, bei dem der Gehalt an CuO oder an $Cu_2O$ in der Dispersion im Bereich von 20 bis 80 % ist.

**5.** Verfahren nach dem Anspruch 4, bei dem vorzugsweise das Kupferoxid $Cu_2O$ ist und das Reagens ein Dismutationsmittel ist.

**6.** Verfahren nach dem Anspruch 5, bei dem das Dismutationsmittel aus der durch die Essig-, Ameisen-, Salpeter-, Oxal-, Phosphor-, Sulfamin-, Schwefel- und Weinsäuren gebildeten Gruppe gewählt wird.

**7.** Verfahren nach dem Anspruch 4, bei dem man $Cu_2O$ mit einem Salz, vorzugsweise einem in Wasser löslichem Sulfid reagieren läßt.

**8.** Verfahren zur Herstellung einer durchgehenden Metallabscheidung (11) auf einem nichtleitenden Substrat (1), das die folgenden Schritte aufweist:

a) man stellt eine Dispersion (4a) eines elektrisch leitenden Pulvers im Teilchenzustand her, die ein Lösungsmittel und ein Bindemittel aufweist, das zur Bildung eines für ein Reagens und das Elektrolysebad des Schritts c) durchlässigen Films nach Beseitigung des Lösungsmittels ausgewählt wird,

b) man bringt die Dispersion (4a) auf das nichtleitende Substrat (1) auf und bildet auf dem nichtleitenden Substrat eine dünne Schicht (9a), die das leitende Pulver im Teilchenzustand aufweist, und

c) man scheidet direkt ohne Zwischenschritt durch elektrolytische Abscheidung aus einem Elektrolysebad eine Metallschicht auf der Cu aufweisenden Schicht (9a) ab.

**9.** Verfahren nach dem Anspruch 8, bei dem das leitende Pulver vorzugsweise ein Graphitpulver einer Teilchengröße unter 50 μm ist.

**10.** Verfahren nach irgendeinem der Ansprüche 1 bis 9, bei dem man im Schritt b) des Verfahrens die fluide Dispersion (4, 4a) auf das nichtleitende Substrat (1) durch Beschichten, Eintauchen, Engobieren, Spritzen oder jedes andere, besonders in den Drucktechniken (Siebdruck, Gummidruck ...) oder denen der Malerei einschließlich der industriellen Malerei bekannte Verfahren aufbringt, um eine Dispersion in dünner Schicht mit einer Dicke unter 30 μm auf dem Substrat zu bilden.

**11.** Verfahren nach dem Anspruch 10, bei dem man im Schritt b) des Verfahrens die Dispersion (4, 4a) auf das nichtleitende Substrat mit Hilfe einer Maske, typisch durch Siebdruck, derart aufbringt, um nach der elektrolytischen Abscheidung metallische Leiterbahnen, vorzugsweise aus Kupfer, zu erhalten.

**12.** Verfahren nach irgendeinem der Ansprüche 10 und 11, bei dem man im Schritt b) des Verfahrens, nach Aufbringen der Dispersion (4, 4a) auf das Substrat, die dünne Schicht (5, 9a) nach jedem bekannten Verfahren zum Festlegen einer Dispersion und typisch entweder durch Verdampfen des Lösungsmittels oder durch Ausflocken des Bindemittels oder durch Warmaufbringen der Dispersion mit nachfolgendem Abkühlen usw. bildet.

**13.** Verfahren nach irgendeinem der Ansprüche 1 bis 12, bei dem man die elektrolytische Abscheidung des metallischen Stoffes vorzugsweise in einem oder mehreren Elektrolysebädern in zwei Zeiten durchführt:

- in einer ersten Zeit stellt man eine "primäre" metallische Abscheidung auf der erfindungsgemäß behandelten Oberfläche (der nach den Schritten a), b) und c) in dem Fall erhaltenen Oberfläche, wo eine $Cu_2O$-Dispersion verwendet wird, oder der nach den Schritten in dem Fall erhaltenen Oberfläche, wo eine Dispersion leitfähigen Pulvers verwendet wird) durch Wachstum und Ausbreitung eines Metallfilms von wenigstens einem Punkt elektrischen Kontakts der Elektrode und der behandelten Oberfläche aus her, bis durch Vorrücken der Wachstumsfront des Metallfilms der "primäre" Metallfilm die behandelte Oberfläche bedeckt, wobei die Dicke des Metallfilms gering und typisch unter 10 µm ist, und

- in einer zweiten Zeit erhöht man die Dicke des "primären" Metallfilms bis zum Erhalten der für die Metallabscheidung gewünschten Dicke.

14. Verfahren nach dem Anspruch 13, bei dem man in einer ersten Zeit den "primären" Metallfilm erhält, indem man nach und nach die Stärke des Elektrolysestroms bis zum Erhalten einer Maximalstärke $I_{max}$ erhöht, die typisch während der zweiten Zeit verwendet wird, und die Bewegung des Elektrolysebades begrenzt.

15. Verfahren nach dem Anspruch 14, bei dem die fortschreitende Stärkenerhöhung ($dI_{max}/dt$) möglichst hoch, jedoch unter einem experimentell bestimmbaren Grenzwert ($dI_{max}/dt)_{max}$ gewählt wird, jenseits dessen ein Aufhören des Wachstums und der Ausbreitung des Films stattfindet, bevor die Gesamtheit der behandelten Oberfläche des Metallfilms bedeckt ist.

16. Verfahren nach irgendeinem der Ansprüche 1 bis 15, bei dem das Bindemittel in der Dispersion (4) in einem Gewichtsgehalt unter 20 Gew.% ist und derart gewählt wird, um 1) als Funktion des Lösungsmittels (das Bindemittel muß im Lösungsmittel löslich oder fein dispergierbar sein) eine stabile Dispersion (4) des Kupferoxids oder des leitfähigen Pulvers zu erhalten, 2) eine durchgehende dünne Schicht (5, 9a) auf dem Substrat nach teilweiser oder gesamter Entfernung des Lösungsmittels zu bilden und 3) eine dünne Schicht (9, 9a) zu bilden, die ihre Unversehrtheit in einem Elektrolysebad bewahrt.

17. Verfahren nach dem Anspruch 16, bei dem das Bindemittel auf der Basis eines Versuchs ausgewählt wird, der die Schritte a) bis d) mit der Bildung einer das Kupferoxid aufweisenden dünnen Schicht umfaßt, bei welchem die anderen als die das Bindemittel und sein Lösungsmittel betreffenden Parameter vorbestimmt wurden:

im Schritt a) stellt man die Dispersion (4) her, die gewichtsmäßig 50 % $Cu_2O$ und etwa 10 % des zu prüfenden Bindemittels und 40 % seines Lösungsmittels enthält,

im Schritt b) bringt man die Dispersion (4) auf eine Platte (1) des zu metallisierenden Isoliermaterials (10 cm x 20 cm x 1 cm) als eine Schicht (5) von 25 µm Dicke auf und man bildet eine dünne Schicht (5a) durch Entfernen des Lösungsmittels bei einer ausreichend niedrigen Temperatur zum Vermeiden einer Polymerisierung oder Vernetzung des Bindemittels im Fall eines thermisch polymerisierbaren oder vernetzbaren Bindemittels,

im Schritt c) behandelt man die mit der $Cu_2O$-Dispersion bedeckte Platte mit 10gew.%iger Schwefelsäure während 1 Minute, um die Dismutation von $Cu_2O$ zu bewirken und eine dünne, Cu-Teilchen enthaltende Schicht (9) zu bilden, und spült die Platte mit Wasser, und

im Schritt d) unterwirft man die am Ausgang des Schritts c) erhaltene Platte einem Versuch zur elektrolytischen Cu-Abscheidung unter den Bedingungen der Bildung der "primären" Metallschicht und wählt das Bindemittel aus, wenn sich durch Wachstum und Ausbreitung fortschreitend ein die Gesamtheit der dünnen Schicht (9) bedeckender "primärer" Metallfilm bildet.

18. Verfahren nach irgendeinem der Ansprüche 16 oder 17, bei dem das Lösungsmittel vorzugsweise unter den organischen Lösungsmitteln gewählt wird und das Bindemittel vorzugsweise unter den Oligomeren, Vorpolymeren oder Polymeren geringen Molekulargewichts mit polaren Gruppen gewählt wird.

19. Verfahren nach irgendeinem der Ansprüche 16 oder 17, bei dem das Bindemittel unter den thermoplastischen Harzen (Celluloseacetobutyrat-, Acryl-, Polyamid-, Polystyrol-, Vinylisobutyletherharzen ...) und den vor Vernetzung wärmehärtbaren Harzen (Silicon-, Epoxid-, Phenoxy-, Polyesterharzen ...) gewählt wird.

20. Verfahren nach dem Anspruch 19, bei dem das Bindemittel vorzugsweise unter den Siliconharzen gewählt wird.

21. Verfahren nach irgendeinem der Ansprüche 1 bis 20, bei dem das nichtleitende Substrat (1) aus der durch die ebenen Materialien (Kunststofffilme auf Spule, Gewebe, nichtgewebte Bahnen, Filze auf Spulen usw. ...), die Formmaterialien (Formteile, Rohre usw. ...) und die zellenförmigen Materialien mit offener Porosität (Kunststoffschäume, Filze aus Textilmaterial usw. ...) gebildeten Gruppe, gewählt wird.

**22.** Verfahren nach dem Anspruch 21, bei dem das Substrat (1) ein Bandmaterial oder aus Formaten ist und die Schritte des Verfahrens kontinuierlich durchgeführt werden.

**23.** Verfahren nach irgendeinem der Ansprüche 1 bis 22, bei dem man am Ausgang des Schritts zur Bildung der Metallschicht (11) die Metallschicht (11) vom nichtleitenden Substrat (1) vorzugsweise durch physikalische Trennung, Pyrolyse oder chemische Auflösung trennt.

**24.** Verfahren nach irgendeinem der Ansprüche 1 bis 22, bei dem man am Ausgang des Schritts zur Bildung der Metallschicht (11) die Metallschicht (11) nicht vom nichtleitenden Substrat (1) trennt und eventuell die Haftung zwischen dem nichtleitenden Substrat (1) und der Metallschicht (11) verstärkt, indem das Bindemittel nach Bildung der Metallschicht (11) polymerisiert oder vernetzt wird.

**Claims**

**1.** A process for producing a continuous metallic deposit (11) on a non-conductive substrate (1), comprising the following steps:

> a) a dispersion (4) is prepared of a copper oxide in the divided state, which is capable of being converted, at least in part, to the state of metallic copper by the action of a reagent, comprising a solvent and a binder selected to form, after removal of the solvent, a film which is permeable to said reagent and to said electrolysis bath of step (d),
> b) said dispersion is applied to said non-conductive substrate (1), and a thin layer (5) is formed on said non-conductive substrate comprising said copper oxide in the divided state;
> c) Cu is formed from said copper oxide by the action of said reagent, so as to obtain on the surface of the non-conductive substrate a thin layer (9) comprising Cu,
> d) a metallic layer is deposited directly, without any intermediate steps, onto said layer (9) comprising Cu, by electrolytic deposition from an electrolysis bath.

**2.** A process according to Claim 1, wherein said copper oxide is either $CuO$ or $Cu_2O$, said reagent being a reducing agent in the case of $CuO$, said reagent being either a reducing agent or a dismutation agent in the case of $Cu_2O$.

**3.** A process according to Claim 2, wherein said dispersion (4) of $CuO$ or of $Cu_2O$ in a solvent, prepared in step a) of the process, comprises a fine dispersion of $CuO$ or of $Cu_2O$ in the form of particles with an average size of less than 30 μm, and preferably less than 10 μm.

**4.** A process according to Claim 3, wherein the content of $CuO$ or of $Cu_2O$ in said dispersion (4) is between 20 and 80%.

**5.** A process according to Claim 4, wherein it is preferable if said copper oxide is $Cu_2O$ and said reagent is a dismutation agent.

**6.** A process according to Claim 5, wherein said dismutation agent is selected from the group formed by acetic, formic, nitric, oxalic, phosphoric, sulfamic, sulfuric, tartaric acids.

**7.** A process according to Claim 4, wherein $Cu_2O$ is reacted with a salt, preferably a sulphide which is soluble in water.

**8.** A process for producing a continuous metallic deposit (11) on a non-conductive substrate (1), comprising the following steps:

> a) a dispersion (4a) is prepared of an electrically conductive powder in the divided state, comprising a solvent and a selected binder to form, after removal of the solvent, a film which is permeable to said reagent and to said electrolysis bath from step c),
> b) said dispersion (4a) is applied to said non-conductive substrate (1), and a thin layer (9a) is formed on said non-conductive substrate, comprising said conductive powder in the divided state,
> c) a metallic layer is deposited directly, without any intermediate steps, on said layer (9a) comprising Cu, by electrolytic deposition from an electrolysis bath.

9.  A process according to Claim 8, wherein said conductive powder is preferably a graphite powder with a particle size of less than 50 $\mu$m.

10. A process according to any one of Claims 1 to 9, wherein, in step b) of the process, said fluid dispersion (4, 4a) is applied to said non-conductive substrate (1) by coating, dipping, slip painting, spraying or any other method which is known particularly in the techniques of printing (silk screen process, flexographic printing, etc.) or the techniques of painting, including industrial painting, for applying a dispersion in the form of a thin layer with a thickness of less than 30 $\mu$m on a substrate.

11. A process according to Claim 10, wherein, in step b) of the process, said dispersion (4, 4a) is applied to said non-conductive substrate (1) using a mask, typically by a silk screen process, in order to obtain conductive metal tracks, preferably of copper, after electrolytic deposition.

12. A process according to either Claim 10 or Claim 11, wherein, in step (b) of said process, following application of said dispersion (4, 4a) to said substrate, said thin layer (5, 9a) is formed by any known method for setting a dispersion, and typically by evaporating said solvent, or by flocculating said binder, or by applying said dispersion with heat and then cooling, etc. . .

13. A process according to any one of Claims 1 to 12, wherein electrolytic deposition of said metallic species is preferably carried out in one or a plurality of electrolysis baths, in two steps:

    - firstly, a "primary" metallic deposit is effected on the surface treated in accordance with the invention (surface obtained following steps a), b) and c) in instances where a dispersion of $Cu_2O$ is used, or following steps a) and b) in instances where a dispersion of conductive powder is used), by growth and propagation, from at least one point of electrical contact of the electrode and said treated surface, of a metallic film until, by advance of the growth front of said metallic film, said "primary" metallic film covers said treated surface, the thickness of said metallic film being small and typically less than 10 $\mu$m,
    - secondly, the thickness of said "primary" metallic film is increased in order to obtain the desired thickness for said metallic deposit.

14. A process according to Claim 13, wherein first of all said "primary" metallic film is obtained by gradually increasing the intensity of the electrolysis current until a maximum intensity $I_{max}$ is obtained which is typically that used during said second step, and by limiting the stirring of said electrolysis bath.

15. A process according to Claim 14, wherein the gradual increase in intensity $(dI_{max}/dt)$ is selected so that it is as high as possible but below a limit value which can be determined experimentally $(dI_{max}/dt)_{max}$ and beyond which growth and propagation of said film stops before all of said treated surface becomes covered with said metallic film.

16. A process according to any one of Claims 1 to 15, wherein less than 20% by weight of said binder is contained in said dispersion (4) and wherein said binder is selected in order to 1) obtain, as a function of said solvent (binder which must be soluble or able to be finely dispersed in said solvent), a stable dispersion (4) of said copper oxide or of said conductive powder, 2) form a continuous thin layer (5, 9a) on said substrate, including after partial or total removal of said solvent, 3) form a thin layer (9, 9a) which retains its integrity in an electrolysis bath.

17. A process according to Claim 16, wherein said binder is selected on the basis of a test which comprises steps a) to d) of said process which comprises formation of a thin layer (9) comprising said copper oxide, wherein the parameters other than those relating to the binder and to its solvents are predetermined:

    in step a), said dispersion (4) is prepared which contains, by weight, 50% $Cu_2O$, and substantially 10% of said binder to be tested, and 40% of its solvent;
    in step b), said dispersion (4) is applied to a panel of insulating material (1) which is to be metallized (10 cm x 20 cm x 1 cm), a layer (5) of 25 $\mu$m in thickness, and a thin layer (5a) is formed by removing the solvent at a temperature which is low enough not to polymerise or cross-link said binder in instances where the binder can be thermally polymerised or crosslinked.
    in step c), said panel which is covered with the $Cu_2O$ dispersion is treated with 10% by weight of sulfphuric acid for 1 minute in order to carry out dismutation of the $Cu_2O$ and form a thin layer (9) containing Cu particles, and the panel is then rinsed in water. in step d), the panel obtained at the end of step c) is subjected to a test of electrolytic deposition of Cu under the conditions for formation of said "primary" metallic layer, and said binder is selected, if, by growth and propagation of a metallic film, a "primary" metallic film covering all of said thin layer (9) gradually forms.

18. A process according 10 either Claim 16 or Claim 17, wherein said solvent is preferably selected from organic solvents, and said binder is preferably selected from low-molecular weight oligomers, prepolymers or polymers with polar groups.

19. A process according to either Claim 16 or Claim 17, wherein said binder is selected from thermoplastic resins (cellulose acetate butyrates, acrylics, polyamides, polystyrenes, vinyl isobutyl ethers etc...), resins that can be heat-hardened before cross-linking (silicone resins, epoxy resins, phenoxy resins, polyesters, etc...).

20. A process according to Claim 19, wherein said binder is preferably selected from silicone resins.

21. A process according to any one of Claims 1 to 20, wherein said non-conductive substrate (1) is selected from the group formed by flat materials (plastic films in wound form, fabrics, non-woven materials, felts in wound form, etc.), moulded materials (moulded parts, tubes, etc.), cellular materials with apparent porosity (foams made of plastic material, felts made of textile material, etc.).

22. A process according to Claim 21, wherein said substrate (1) is a material in strip form or in formats and in which the steps of said process are carried out continuously.

23. A process according to any one of Claims 1 to 22, wherein, after the step for formation of said metallic layer (11), said metallic layer (11) is separated from said non-conductive substrate (1), preferably by physical separation, pyrolysis or chemical dissolution.

24. A process according to any one of Claims 1 to 22, wherein, after the step for formation of said metallic layer (11), said metallic layer (11) is not separated from said non-conductive substrate (1), and the adhesion between said non-conductive substrate (1) and said metallic layer (11) is possibly reinforced by polymerising or cross-linking said binder after said metallic layer (11) has formed.

FIG.1

FIG.2

FIG.3

FIG. 4

FIG.5b

FIG.5a

FIG.6

FIG.7